# EUROPEAN PATENT SPECIFICATION

(11) **EP 1 890 526 B1**
(45) Date of publication and mention of the grant of the patent: **14.10.2009**
(21) Application number: 06119181.3
(22) Date of filing: 18.08.2006
(51) Int. Cl.: H05K 9/00

(54) **Handheld electronic device including multi-compartment shielding container and associated methods**
Tragbares elektronisches Gerät beinhaltend elektromagnetische Abschirmung mit mehreren Kammern und dazugehörige Verfahren
Dispositif électronique portable comprenant l'écran de blindage à compartiments multiples et procédés associés

(43) Date of publication of application: 20.02.2008
(73) Proprietor: Research In Motion Limited, Waterloo, Ontario N2L 3W8 (CA)
(72) Inventor: Chen, Chao, Waterloo, Ontario N2T 2T8 (CA); Fregin, Douglas, Waterloo, Ontario N2L 1W7 (CA); Regenwetter, Jana, Milton, Ontario L9T 5S7 (CA)
(74) Representative: Hibbert, Juliet Jane Grace

(56) References cited:
- DE-U1- 29 913 199
- US-A- 5 731 964

## Description

### Field of the Invention

The present invention relates to the field of mobile communications, and, more particularly, to shielding within a mobile communication device and related methods.

### Background of the Invention

Cellular communication systems continue to grow in popularity and have become an integral part of both personal and business communications. Cellular telephones allow users to place and receive phone calls most anywhere they travel. Moreover, as cellular telephone technology has increased, so too has the functionality of cellular devices. For example, many cellular devices now incorporate Personal Digital Assistant (PDA) features such as calendars, address books, task lists, calculators, memo and writing programs, etc. These multifunction devices usually allow users to wirelessly send and receive electronic mail (email) messages and access the internet via a cellular network and/or a wireless local area network (WLAN), for example.

As the functionality of cellular communications devices continues to increase, so too does the demand for smaller devices that are easier and more convenient for users to carry. As any circuit board and electronic components thereon are reduced in size and placed closer together, including antenna and microphone components, various electronic components can pick up energy and create interference within the system. For example, an internal surface mounted microphone could pick up energy directly from a power amplifier or from the radiated energy emitted by an antenna. This unwanted reception of energy from respective power amplifiers and antennae may be particularly problematic in a packet burst transmission as part of a Global System for Mobile communications (GSM) system, including the 450 MHz, 900 MHz, 1800 MHz and 1900 MHz frequency bands.

Other interfering signals can be generated when the liquid crystal display (LCD) in some mobile wireless communications devices radiates radio frequency (RF) interfering energy and degrades receiver sensitivity. This may be problematic where the interfering energy is generated by the microprocessor or central processing unit (CPU) of a wireless mobile communications device and fed into the LCD lines, along with interfering energy generated by the LCD itself. Other problems may occur when the interfering radio frequency (RF) energy is coupled to the mobile wireless communications device causing audio break through tests to fail for both the uplink and downlink. Even the keyboard circuits can create unwanted interference problems. For example, the radio frequency receiver sensitivity is often degraded by the electromagnetic interference (EMI) of digital harmonics from the microprocessor or CPU via the keyboard because of the resulting loop formed by any keyboard circuits. In some instances, strong RF energy, for example, such as the transmitted power from the radio via the antenna interferes with or couples to the microprocessor or CPU input/output (I/O) lines of a mobile wireless communications device through the keyboard Key-In and Key-Out lines and causes a reset of the microprocessor or CPU.

A shielding container can protect components on a printed circuit board (PCB), preferably for a cellular phone, against interference from other components due to EMI. A shielding container covers a number of electronic components on a printed circuit board, and thereby protects these components from disturbing other electronic components on the printed circuit board. The use of shielding containers is well known because GSM phones have printed circuit boards equipped with different components that may disturb each other if they are not shielded from each other.

A first type of shielding container includes one entire box shaped piece soldered onto the printed circuit board. This type of shielding container does not permit access to components covered by the shielding container, which makes it very difficult to repair or inspect any of the components covered or shielded by the shielding container. An alternative is having holes or apertures to let the heat in to solder the components at the same time as the shielding container.

A second type of shielding container includes two pieces, one frame and one lid. The lid is snapped onto the frame and can be removed from the frame, which is soldered onto the printed circuit board, to enable repairing or inspection of the components shielded by the shielding can. The second type may be attached to the printed circuit board in different ways. One way is to solder the frame onto the printed circuit board first and then attach the lid to the frame. Another way is to snap the lid onto the frame and solder the assembly onto the printed circuit board, but then there is a need for holes or apertures in the lid to let in the heat during soldering. Otherwise the components covered or shielded by the shielding container will not be properly soldered since the heat cannot reach the components. It is preferable to solder the frame with the lid attached to save work operations. However, according to the prior art there may be problems getting a good solder joint, when using a pre-joined shielding container.

U.S. Patent No. 5,895,884 to Davidson is directed to a shielding device with a push fit lid. The shielding device is formed from two unitary pieces, one of which is a generally planar member taking the form of a lid and the other piece takes the form of a side wall member which is adapted for mounting to a substrate surface on which is mounted circuit elements. The two pieces together combine to create the shielding device for inhibiting the passage of electromagnetic radiation to and/or from a group of circuit elements. The lid may have flanges for connection onto the side wall member and the side wall member may have intersecting dividing walls disposed internally thereof.

U.S. Patent No. 6,600,663 to Koleda is directed to a shielding can for a printed circuit which includes a frame with side walls and a lid with increased flexibility from slits on the sides of the lid. These slits enable a flexible contraction, when soldering the shielding can onto the printed circuit board.

U.S. Patent No. 6,137,051 to Bundza is directed to an electromagnetic interference and compatibility (EMI/EMC) shielding enclosure for a printed circuit board (PCB) or other electronic components that has a conductive plastic top housing portion and a conductive bottom housing portion. The top housing portion has projecting fingers integral therewith. The bottom housing portion has an inner surface with walls projecting therefrom for substantially encompassing the PCB. When the enclosure is assembled, the PCB is located between the top housing portion and the bottom housing portion, the fingers from the top housing portion surround at least a major portion of the PCB and the fingers physically contact the bottom housing portion or are sufficiently close for capacitive coupling.

There is still a need for a handheld electronic device including a multi-compartment shielding container with inter-compartment shielding and sufficient stiffness to be used for printed circuit boards within the electronic device.

DE 299 13 199 U1 (Siemens) discloses a shield for an electrical assembly composed of a plurality of electrical elements and disposed on a circuit board, the shield having a substantially L-shaped frame.

The main aspects of the subject invention are as set out in the independent claims. Major subsidiary features are as set out in the dependent claims.

### Brief Description of the Drawings

FIG. 1 is an exploded end view of a handheld electronic device according to the present invention.

FIG. 2 is a perspective view of the shielding frame as shown in FIG. 1.

FIG. 3 is an enlarged perspective view of a portion of the shielding frame as shown in FIG. 2.

FIG. 4 is a cross-sectional view taken along the line 4-4 of FIG. 3.

FIG. 5 is a perspective view of the shielding lid as shown in FIG. 1.

FIGs. 6 and 7 are enlarged views of embodiments of a wrap-around corner of the shielding frame as shown in FIG. 2.

FIG. 8 is a more detailed schematic block diagram of an alternative embodiment of a handheld electronic device according to the invention.

### Detailed Description of the Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

In view of the foregoing background, it is therefore an object of the present invention to provide a handheld electronic device including a multi-compartment shielding container with inter-compartment shielding and sufficient stiffness. This and other objects, features, and advantages in accordance with the present invention are provided by a handheld electronic device including a portable housing and a shielding container within the portable housing. The shielding container may include a shielding frame and a shielding lid carried thereby. A printed circuit board may be adjacent the shielding container. The shielding frame may include a base being generally planar and having at least one opening therein, a pair of opposing side walls integrally formed with the base and extending upwardly therefrom, and a pair of opposing end walls integrally formed with the base and extending upwardly therefrom. Also, the shielding frame may include at least one intermediate partition wall integrally formed with the base and extending upwardly therefrom to define a plurality of container compartments. The partition wall may extend only partway between the opposing side walls to define at least one partition end gap therewith.

Preferably, the pair of opposing side walls includes at least one side wall stiffening feature incorporated therein. The at least one partition end gap may comprise a pair thereof, and the stiffening feature may include a respective stiffening feature adjacent each partition end gap. The side wall stiffening feature is preferably a radiused corner defined with adjacent portions of the base. For example, the radiused corner may have a radius of less than about 5 mm or have a radius in a range of about **0.2 to 1.0 mm.** Also, each of the pair of partition end gaps may be less than about 1 mm to provide adequate shielding within the container compartments, and preferably is in a range of about 0.2 to 0.8 mm, and more preferably in a range of **0.5** to 0.7 mm.

The printed circuit board may be a wireless transceiver printed circuit board, for example. The at least one intermediate partition wall may include a plurality of intermediate partition walls in some embodiments. The shielding frame may be devoid of welded or soldered joints between adjacent portions thereof. In addition, the shielding container may comprise an electrically conductive material and the shielding lid may be substantially continuous.

A method aspect is directed to making a shielding container for at least one printed circuit board of a handheld electronic device. The method may include forming a shielding frame and forming a shielding lid carried by the shielding frame. Forming the shielding frame may include forming a planar base having at least one opening therein, integrally forming a pair of opposing side walls with the base and extending upwardly therefrom, and integrally forming a pair of opposing end walls with the base and extending upwardly therefrom. Also, the method may include integrally forming at least one intermediate partition wall with the base and extending upwardly therefrom to define a plurality of container compartments, the at least one partition wall may also extend only partway between the opposing side walls to define at least one partition end gap therewith. At least one side wall stiffening feature may be formed in the pair of opposing side walls.

The at least one partition end gap may comprise a pair thereof, and forming the at least one stiffening feature may include forming a respective stiffening feature adjacent each partition end gap. Forming the at least one side wall stiffening feature may include forming a radiused corner defined with adjacent portions of the base.

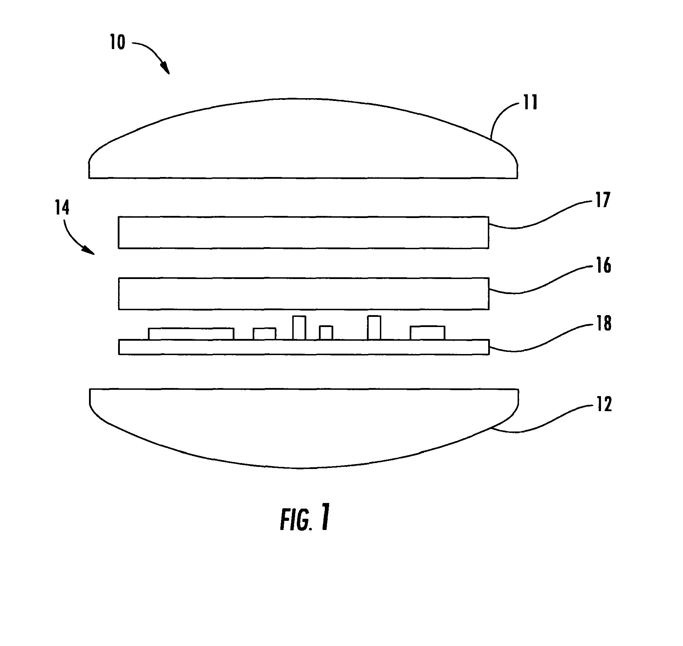

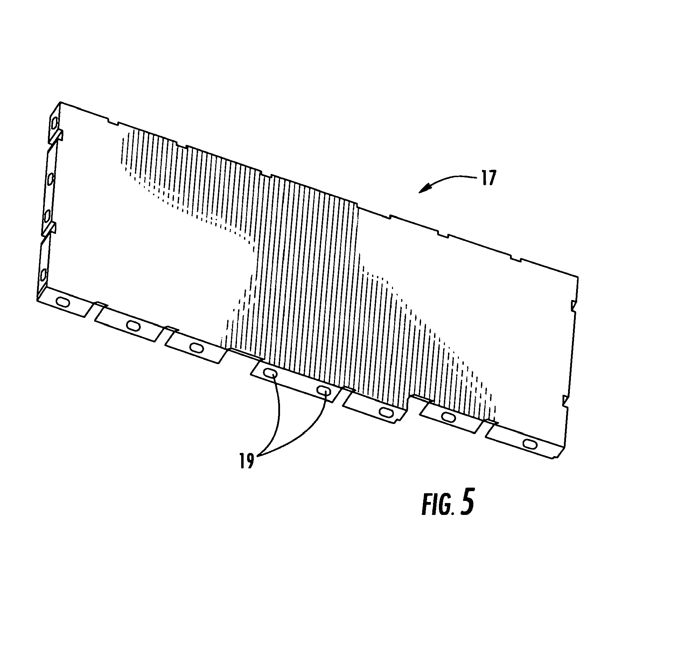

Referring initially to FIGS. 1-5, a handheld electronic device **10** illustratively includes a portable housing and a shielding container **14** within the portable housing comprising upper and lower housing portions **11, 12.** The shielding container **14** includes a shielding frame **16** and a shielding lid **17** carried thereby. The shielding lid **17** may be substantially continuous and attached to the shielding frame **16** as will be appreciated by those skilled in the art. A plurality of tabs **19** are positioned along flanges of the shielding lid **17** to be aligned with attaching holes **21** along the opposing side walls **24, 26** and end walls **28, 30** of the shielding frame **16,** discussed below, thereby securing the shielding lid **17** to the shielding frame **16.** A printed circuit board **18** is adjacent the shielding container **14,** such as a wireless transceiver printed circuit board, for example.

The shielding frame **16** includes a generally planar base **20** with a plurality of openings **22a-22d** therein, a pair of opposing side walls **24, 26** integrally formed with the base and extending upwardly therefrom, and a pair of opposing end walls **28, 30** integrally formed with the base and extending upwardly therefrom. Also, the shielding frame **16** includes an intermediate partition wall **32** integrally formed with the base **20** and extending upwardly therefrom to define a pair of container compartments **34, 36.** The partition wall **32** extends only partway between the opposing side walls **24, 26** to define a pair of partition end gap **38, 40** therewith. In the illustrated embodiment, a second partition wall **39** may extend upwardly from the base **20** and define only a single partition end gap **41.**

Each of the pair of partition end gaps **38, 40** may have a dimension **d** less than about 1 mm to provide adequate shielding within the container compartments yet facilitating manufacturing. The gap dimension **d** may preferably be in a range of about 0.2 to 0.8 mm, and more preferably in a range of 0.5 to 0.7 mm. Providing the pair of partition end gaps **d** in these ranges also contributes to the pair of opposing side walls **24, 26** imparting a sufficient stiffness to the shield frame **16.**

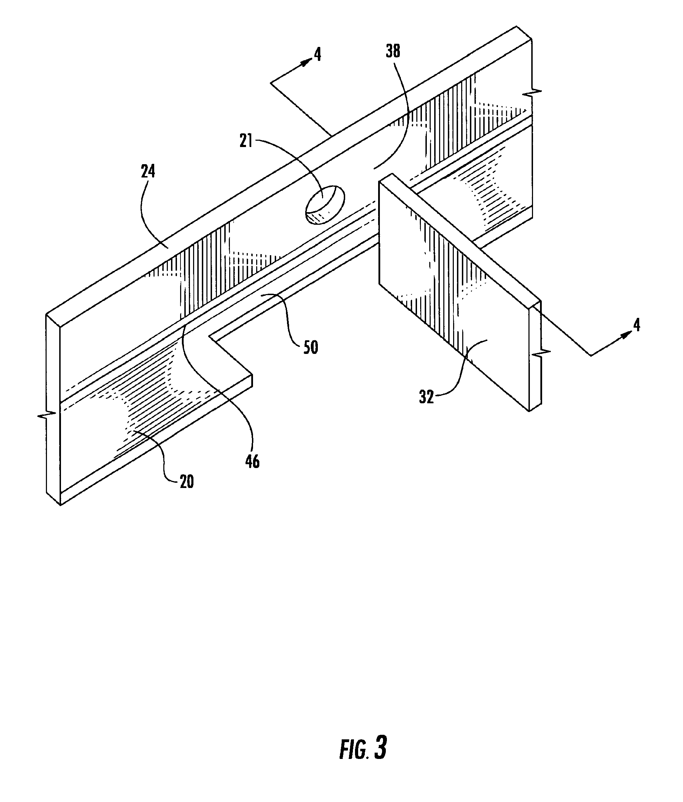

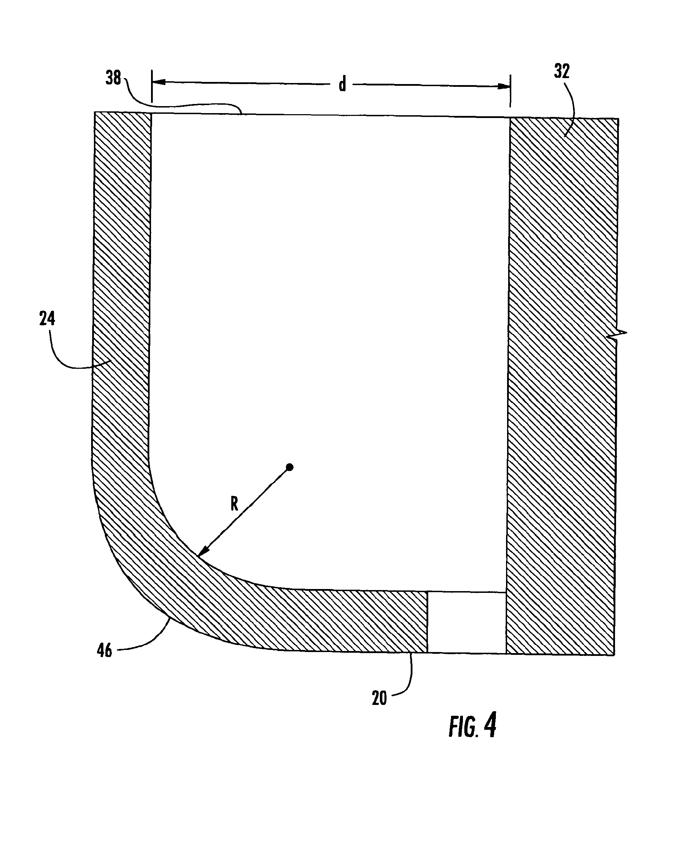

Referring more specifically to FIGS. 3 and 4, the pair of opposing side walls **24, 26** includes at least one side wall stiffening feature **50** incorporated therein, adjacent the partition end gap **38.** The side wall stiffening feature is illustratively provided by a radiused corner **46** defined with adjacent portions of the base **20.** For example, the radiused corner **46** may have a radius **R** of less than about 5 mm or have a radius in a range of about 0.2 to 1.0 mm. The radiused corner may be used adjacent the other partition end gaps, **40, 41** as will be appreciated by those skilled in the art. The stiffening features may help yield a sufficient coplanarity of the base **20,** such as within 0.1~0.15 mm, for example, so to avoid the need to solder adjacent portions of the shielding frame **16,** as will also be appreciated by those skilled in the art. Accordingly, the shielding frame **16** may be devoid of welded or soldered joints between adjacent portions thereof. The shielding container **14** may comprise an electrically conductive material such as a stamped and folded copper sheet.

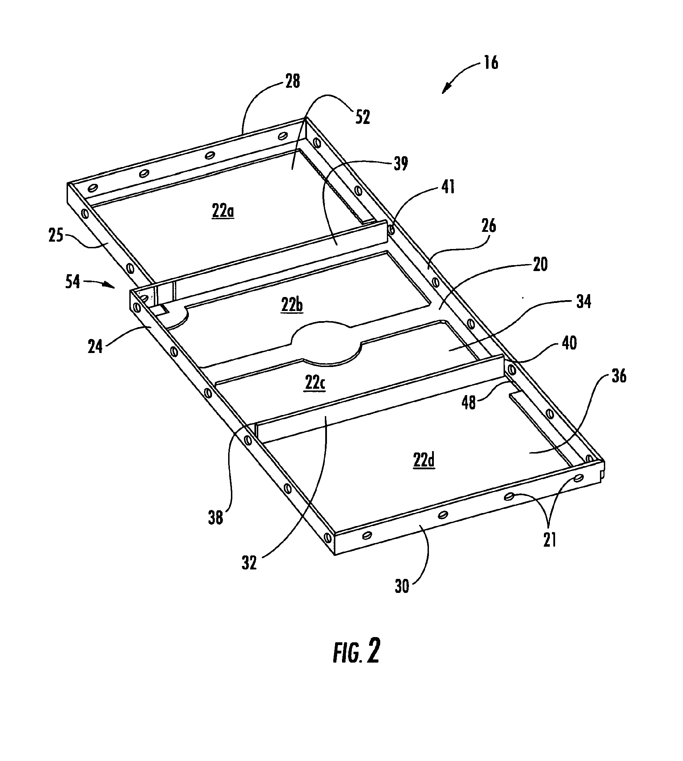

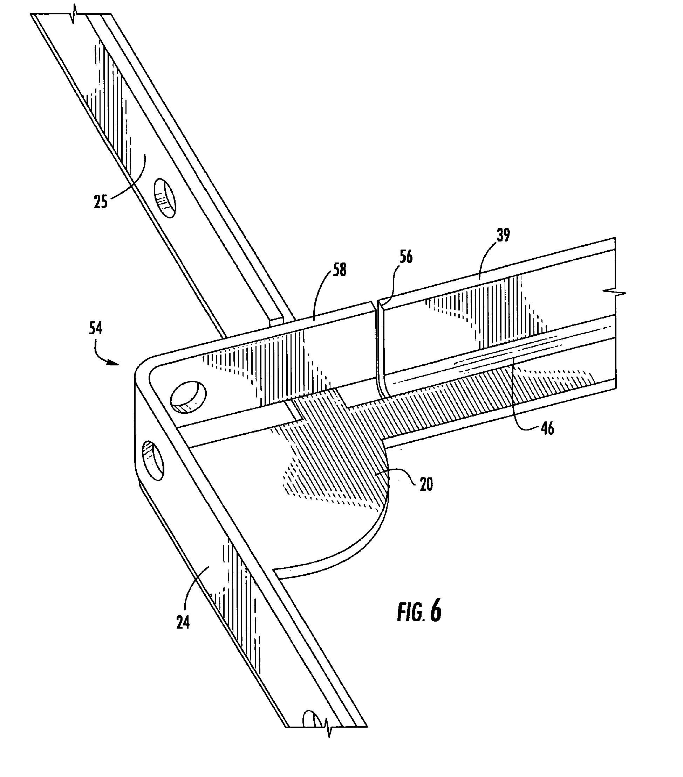

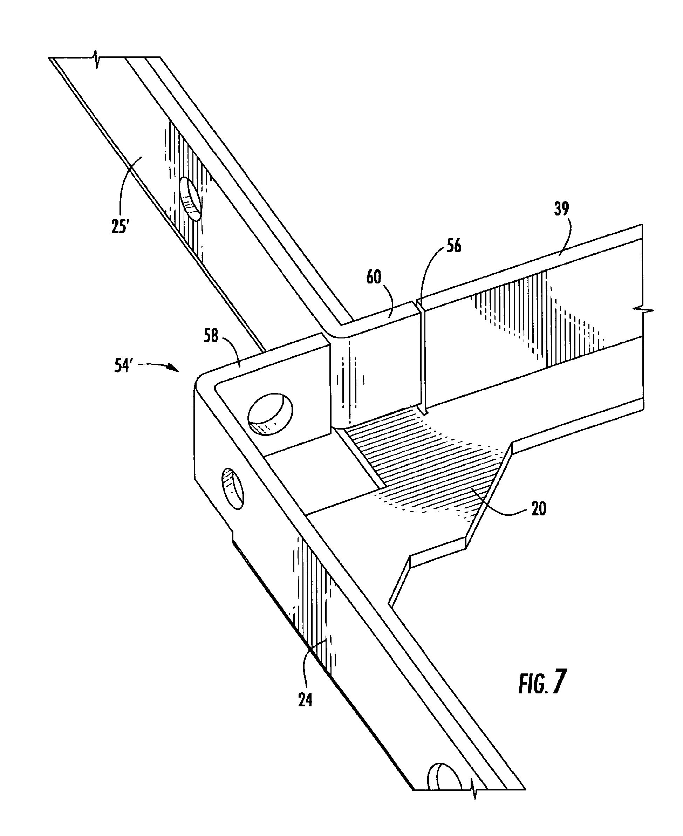

Referring more specifically to FIGs. 2, 6 and 7, the second partition wall **39,** along with the offset side wall **25,** may define a relatively smaller or more narrow container compartment **52.** As such, a wrap-around corner **54** is defined between the second partition wall **39** and the side wall **24.** The side wall **24** preferably includes a corner extension **58** that is perpendicular to the side wall **24** and in-line with the second partition wall **39.** In one embodiment (FIG. 6), the corner extension **58** extends to adjacent the second partition wall **39** with a gap **56** therebetween. In an alternative embodiment (FIG. 7), the wrap-around corner **54'** includes the corner extension **58** along with an offset side wall extension **60,** of the offset side wall **25',** between the corner extension **58** and the second partition wall **39.** In this embodiment, the gap **56** is between the offset side wall extension **60** and the second partition wall **39.** The embodiment illustrated in FIG. 6 also includes the radiused corner **46** as a stiffening feature defined between the second partition wall **39** and adjacent portions of the base **20.**

A method aspect is directed to making a shielding container **14** for a printed circuit board **18** of a handheld electronic device **10.** The method includes forming a shielding frame **16** and forming a shielding lid **17** carried by the shielding frame. Forming the shielding frame **16** includes forming a planar base **20** having at least one opening **22** therein, integrally forming a pair of opposing side walls **24, 26** with the base and extending upwardly therefrom, and integrally forming a pair of opposing end walls **28, 30** with the base and extending upwardly therefrom. Also, the method includes integrally forming an intermediate partition wall **32** with the base **20** and extending upwardly therefrom to define a plurality of container compartments **34, 36.** The partition wall **32** may also extend only partway between the opposing side walls **24, 26** to define one or a pair of partition end gaps therewith.

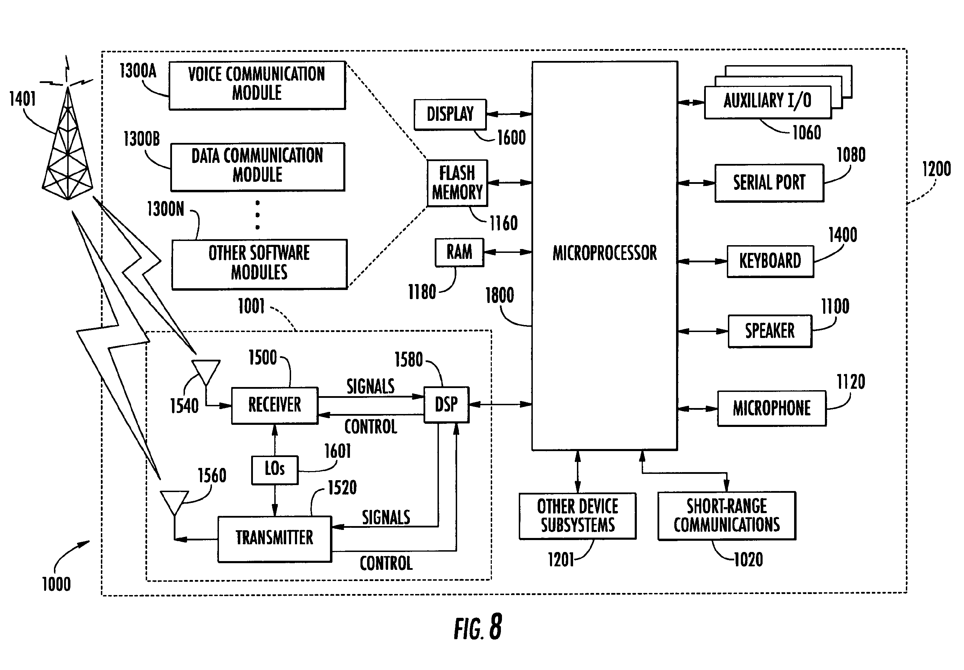

One example of a hand-held mobile wireless communications device **1000** that may be used is further described in the example below with reference to FIG. 8. The device **1000** illustratively includes a housing **1200,** a keypad **1400** and an output device **1600.** The output device shown is a display **1600,** which is preferably a full graphic LCD. Other types of output devices may alternatively be utilized. A processing device 1800 is contained within the housing 1200 and is coupled between the keypad 1400 and the display 1600. The processing device 1800 controls the operation of the display 1600, as well as the overall operation of the mobile device 1000, in response to actuation of keys on the keypad 1400 by the user.

The housing 1200 may be elongated vertically, or may take on other sizes and shapes (including clamshell housing structures). The keypad may include a mode selection key, or other hardware or software for switching between text entry and telephony entry.

In addition to the processing device 1800, other parts of the mobile device 1000 are shown schematically in FIG. 8. These include a communications subsystem 1001; a short-range communications subsystem 1020; the keypad 1400 and the display 1600, along with other input/output devices 1060, 1080, 1100 and 1120; as well as memory devices 1160, 1180 and various other device subsystems 1201. The mobile device 1000 is preferably a two-way RF communications device having voice and data communications capabilities. In addition, the mobile device 1000 preferably has the capability to communicate with other computer systems via the Internet.

Operating system software executed by the processing device 1800 is preferably stored in a persistent store, such as the flash memory 1160, but may be stored in other types of memory devices, such as a read only memory (ROM) or similar storage element. In addition, system software, specific device applications, or parts thereof, may be temporarily loaded into a volatile store, such as the random access memory (RAM) **1180.** Communications signals received by the mobile device may also be stored in the RAM **1180.**

The processing device **1800,** in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM is preferably capable of organizing and managing data items, such as e-mail, calendar events, voice mails, appointments, and task items. The PIM application is also preferably capable of sending and receiving data items via a wireless network **1401.** Preferably, the PIM data items are seamlessly integrated, synchronized and updated via the wireless network **1401** with the device user's corresponding data items stored or associated with a host computer system. Communication functions, including data and voice communications, are performed through the communications subsystem **1001,** and possibly through the short-range communications subsystem. The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex^{™}, Data TAC^{™} or General Packet Radio Service (GPRS) mobile data communications networks, and also designed to operate with any of a variety of voice communications networks, such as AMPS, TDMA, CDMA, PCS, GSM, etc. Other types of data and voice networks, both separate and integrated, may also be utilized with the mobile device **1000.**

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore requires a subscriber identity module, commonly referred to as a SIM card, in order to operate on a GPRS network.

When required network registration or activation procedures have been completed, the mobile device **1000** may send and receive communications signals over the communication network **1401.** Signals received from the communications network **1401** by the antenna **1540** are routed to the receiver **1500,** which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP **1580** provides for control of the receiver **1500** and the transmitter **1520.** For example, gains applied to communications signals in the receiver **1500** and transmitter **1520** may be adaptively controlled through automatic gain control algorithms implemented in the DSP **1580.**

In a data communications mode, a received signal, such as a text message or web page download, is processed by the communications subsystem **1001** and is input to the processing device **1800.** The received signal is then further processed by the processing device **1800** for an output to the display **1600,** or alternatively to some other auxiliary I/O device **1060.** A device user may also compose data items, such as e-mail messages, using the keypad **1400** and/or some other auxiliary I/O device **1060,** such as a touchpad, a rocker switch, a thumb-wheel, or some other type of input device. The composed data items may then be transmitted over the communications network **1401** via the communications subsystem **1001.**

In a voice communications mode, overall operation of the device is substantially similar to the data communications mode, except that received signals are output to a speaker **1100,** and signals for transmission are generated by a microphone **1120.** Alternative voice or audio I/O subsystems, such as a voice message recording subsystem, may also be implemented on the device **1000.** In addition, the display 1600 may also be utilized in voice communications mode, for example to display the identity of a calling party, the duration of a voice call, or other voice call related information.

The short-range communications subsystem enables communication between the mobile device **1000** and other proximate systems or devices, which need not necessarily be similar devices. For example, the short-range communications subsystem may include an infrared device and associated circuits and components, or a Bluetooth^{™} communications module to provide for communication with similarly-enabled systems and devices.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. A shielding container (14) for at least one printed circuit board (18) of a handheld electronic device (10), the shielding container (14) comprising:
a shielding frame (16); and,
a shielding lid (17) carried by the shielding frame;
wherein said shielding frame (16) comprises:
a generally-planar base (20) having at least one opening (22b) therein;
a pair of opposing side walls (24, 26; 25, 26) integrally formed with said base (20) and extending upwardly therefrom;
a pair of opposing end walls (28, 30) integrally formed with said base (20) and extending upwardly therefrom; and,
at least one intermediate partition wall (39; 32) integrally formed with said base (20) and extending upwardly therefrom to define a plurality of container compartments (34, 52; 34, 36), said at least one partition wall (39; 32) also extending only partway between said opposing side walls (24, 26; 25, 26) to define at least one partition end gap (56; 38) therewith;
wherein at least one of said side walls comprises an offset side wall (25) which defines at least one narrower compartment (52); and,
where a wrap-around corner is defined adjacent said partition end gap (56), between said partition wall (39), said side wall (24) and said offset side wall (25), said wrap-around corner being defined by a corner extension (58) in the side wall (24), that is perpendicular to the side wall (24) and in-line with the intermediate partition wall (39).

2. The shielding container (14) according to Claim 1, wherein two side walls (24, 25) extend adjacent the respective partition end gap (56), and wherein each of the side wall (24) and the offset side wall (25) has a corner extension (58, 60) that is perpendicular to the respective side wall and in-line with the intermediate partition wall (39).

3. The shielding container (14) according to claim 1 or 2, wherein said pair of opposing side walls (24, 26) comprises at least one side wall stiffening feature (50) incorporated therein.

4. The shielding container (14) according to Claim 2, wherein said at least one partition end gap (56; 38) comprises a pair of partition end gaps (56, 41; 38, 40), and wherein said at least one side wall stiffening feature (50) comprises a respective stiffening feature (46) adjacent each partition end gap (38, 40).

5. The shielding container (14) according to Claim 3, wherein said at least one side wall stiffening feature comprises a radiused corner (46) defined by at least one side wall (24) and adjacent portions of said base (20).

6. The shielding container (14) according to Claim 5, wherein said radiused corner (46) has a radius of less than 5 mm.

7. The shielding container (14) according to Claim 4, wherein the gap of each of said pair of partition end gaps (38, 40) is less than 1 mm.

8. The shielding container (14) according to Claim 1 or 2, wherein said at least one intermediate partition wall (39; 32) comprises a plurality of intermediate partition walls (39, 32).

9. The shielding container (14) according to Claim 1 or 2, wherein said shielding frame (16) is devoid of welded or soldered joints between adjacent portions thereof.

10. A handheld electronic device (10) comprising:
a portable housing (11, 12);
a shielding container (14) within said portable housing (11, 12), the container being the container of any one of claims 1 to 8; and,
the at least one printed circuit board (18), the at least one printed circuit board being adjacent said shielding container.

11. The handheld electronic device (10) of claim 10,
wherein said at least one printed circuit board comprises a wireless transceiver printed circuit board (18).

12. A method for making a shielding container (14) for at least one printed circuit board (18) of a handheld electronic device (10), the method comprising the steps of:
forming a shielding lid (17); and,
forming a shielding frame (16) to carry the shielding lid by performing at least the steps of:
forming a planar base (20) having at least one opening therein;
integrally forming a pair of opposing side walls (24, 26; 25, 26) with the base (20) and extending upwardly therefrom;
integrally forming a pair of opposing end walls (28, 30) with the base (20) and extending upwardly therefrom; and,
integrally forming at least one intermediate partition wall (39; 32) with the base (20) and extending upwardly therefrom to define a plurality of container compartments (34, 52; 34, 36), said at least one partition wall (39; 32) also extending only partway between the opposing side walls (24, 26; 25, 26) to define at least one partition end gap (56; 38) therewith;
wherein integrally forming of at least one of said side walls comprises integrally forming of an offset side wall (25) which defines at least one narrower compartment (52); and, integrally forming of a wrap-around corner adjacent said partition end gap (56), between said partition wall (39), said side wall (24) and said offset side wall (25),
wherein said wrap-around corner is defined by a corner extension (58) in the side wall (24), that is perpendicular to the side wall (24) and in-line with the intermediate partition wall (39).

13. The method according to Claim 12, wherein the forming of the pair of opposing side walls (24, 26; 25, 26) is such that two side walls (24, 25) are formed to extend adjacent the respective partition end gap (56), and wherein each of the side wall (24) and the offset side wall (25) has a corner extension (58, 60) that is perpendicular to the respective side wall and in-line with the intermediate partition wall (39).

14. The method according to Claim 12 or 13, wherein said pair of opposing side walls (24, 26) are formed to include at least one side wall stiffening feature (50) incorporated therein.

15. The method according to Claim 14, wherein said at least one partition end gap (56; 38) comprises a pair of partition end gaps (56, 41; 38, 40), and wherein said at least one side wall stiffening feature comprises a respective stiffening feature (46) adjacent each partition end gap (38, 40).

16. The method according to Claim 12, wherein said at least one side wall stiffening feature (50) comprises a radiused corner (46) defined by at least one side wall (24) and adjacent portions of said base (20).

17. The method according to Claim 13, wherein said radiused corner (46) has a radius of less than 5 mm.

## Patentansprüche

1. Abschirmbehälter (14) für zumindest eine Leiterplatte (18) einer tragbaren elektronischen Vorrichtung (10), wobei der Abschirmbehälter aufweist:
einen Abschirmrahmen (16); und
einen Abschirmdeckel (17), der durch den Abschirmrahmen getragen wird; wobei der Abschirmrahmen (16) aufweist:
eine im Allgemeinen ebene Grundfläche bzw. Basis (20), die zumindest eine Öffnung (22b) darin hat;
ein Paar von gegenüberliegenden Seitenwänden (24, 26; 25, 26), die integral mit der Basis (20) ausgebildet sind und sich davon nach oben erstrecken;
ein Paar von gegenüberliegenden Endwänden (28, 30), die integral mit der Basis (20) ausgebildet sind und sich davon nach oben erstrecken; und
zumindest eine dazwischenliegende Trennwand (39; 32), die integral mit der Basis (20) ausgebildet ist und sich davon nach oben erstreckt, um eine Vielzahl von Behälterkammern (34, 52; 34, 36) zu definieren, wobei sich die zumindest eine Trennwand (39; 32) nur zum Teil zwischen den gegenüberliegenden Seitenwänden (24, 26; 25, 26) erstreckt, um zumindest eine Trennendelücke (56; 38) damit zu definieren;
wobei zumindest eine der Seitenwände eine versetzte Seitenwand (25) aufweist, die zumindest eine schmalere Kammer (52) definiert; und
wobei eine umlaufende Ecke angrenzend an die Trennendelücke (56) zwischen der Trennwand (39), der Seitenwand (24) und der versetzten Seitenwand (25) definiert ist, wobei die umlaufende Ecke durch einen Eckfortsatz bzw. eine Eckverlängerung (58) in der Seitenwand (24) definiert ist, der/die senkrecht ist zu der Seitenwand (24) und in einer Linie mit der dazwischenliegenden Trennwand (39).

2. Abschirmbehälter (14) gemäß Anspruch 1, wobei sich zwei Seitenwände (24, 25) angrenzend an die jeweilige Trennendelücke (56) erstrecken und wobei jede der Seitenwand (24) und der versetzten Seitenwand (25) einen Eckfortsatz (58, 60) hat, der senkrecht zu der jeweiligen Seitenwand und in einer Linie mit der dazwischenliegenden Trennwand (39) ist.

3. Abschirmbehälter (14) gemäß Anspruch 1 oder 2, wobei das Paar von gegenüberliegenden Seitenwänden (24, 26) zumindest ein darin aufgenommenes Seitenwandversteifungsmerkmal (50) aufweist.

4. Abschirmbehälter (14) gemäß Anspruch 2, wobei die zumindest eine Trennendelücke (56; 38) ein Paar von Trennendelücken (56, 41; 38, 40) aufweist, und wobei das zumindest eine Seitenwandversteifungsmerkmal (50) ein jeweiliges Versteifungsmerkmal (46) angrenzend an jede Trennendelücke (38, 40) aufweist.

5. Abschirmbehälter (14) gemäß Anspruch 3, wobei das zumindest eine Seitenwandversteifungsmerkmal ein abgerundetes Eck (46) aufweist, das durch zumindest eine Seitenwand (24) und angrenzende Teile der Basis (20) definiert ist.

6. Abschirmbehälter (14) gemäß Anspruch 5, wobei das abgerundete Eck (46) einen Radius von weniger als 5 mm hat.

7. Abschirmbehälter (14) gemäß Anspruch 4, wobei die Lücke jeder des Paares von Trennendelücken (38, 40) kleiner ist als 1 mm.

8. Abschirmbehälter (14) gemäß Anspruch 1 oder 2, wobei die zumindest eine dazwischenliegende Trennwand (39; 32) eine Vielzahl von dazwischenliegende Trennwänden (39, 32) aufweist.

9. Abschirmbehälter (14) gemäß Anspruch 1 oder 2, wobei der Abschirmrahmen (16) frei von geschweißten oder gelöteten Verbindungen zwischen seinen angrenzenden Teilen ist.

10. Tragbare elektronische Vorrichtung (10), die aufweist:
ein tragbares Gehäuse (11, 12);
einen Abschirmbehälter (14) in dem tragbaren Gehäuse (11, 12), wobei der Behälter der Behälter gemäß einem der Ansprüche 1 bis 8 ist; und
die zumindest eine Leiterplatte (18), wobei die zumindest eine Leiterplatte angrenzend an den Abschirmbehälter vorgesehen ist.

11. Tragbare elektronische Vorrichtung (10) gemäß Anspruch 10, wobei die zumindest eine Leiterplatte eine drahtlose Transceiver-Leiterplatte (18) aufweist.

12. Verfahren zur Herstellung eines Abschirmbehälters (14) für zumindest eine Leiterplatte (18) einer tragbaren elektronischen Vorrichtung (10), wobei das Verfahren die Schritte aufweist:
Ausbilden eines Abschirmdeckels (17); und
Ausbilden eines Abschirmrahmens (16), um den Abschirmdeckel zu tragen, durch Durchführen zumindest der Schritte:
Ausbilden einer ebenen Basis (20) mit zumindest einer Öffnung darin;
integrales Ausbilden eines Paares von gegenüberliegenden Seitenwänden (24, 26; 25, 26), mit der Basis (20) und sich davon nach oben erstreckend;
integrales Ausbilden eines Paares von gegenüberliegenden Endwänden (28, 30), mit der Basis (20) und sich davon nach oben erstreckend; und
integrales Ausbilden zumindest einer dazwischenliegenden Trennwand (39; 32), mit der Basis (20) und sich davon nach oben erstreckend, um eine Vielzahl von Behälterkammern (34, 52; 34, 36) zu definieren, wobei sich die zumindest eine Trennwand (39; 32) nur zum Teil zwischen den gegenüberliegenden Seitenwänden (24, 26; 25, 26) erstreckt, um zumindest eine Trennendelücke (56; 38) damit zu definieren;
wobei ein integrales Ausbilden zumindest einer der Seitenwände ein integrales Ausbilden einer versetzten Seitenwand (25) aufweist, die zumindest eine schmalere Kammer (52) definiert; und
integrales Ausbilden einer umlaufenden Ecke angrenzend an die Trennendelücke (56) zwischen der Trennwand (39), der Seitenwand (24) und der versetzten Seitenwand (25), wobei die umlaufende Ecke durch einen Eckfortsatz (58) in der Seitenwand (24) definiert ist, der senkrecht ist zu der Seitenwand (24) und in einer Linie mit der dazwischenliegenden Trennwand (39).

13. Verfahren gemäß Anspruch 12, wobei das Ausbilden des Paares von gegenüberliegenden Seitenwänden (24, 26) derart ist, dass zwei Seitenwände (24, 25) ausgebildet sind, sich angrenzend an die jeweilige Trennendelücke (56) zu erstrecken, und wobei jede der Seitenwand (24) und der versetzten Seitenwand (25) einen Eckfortsatz (58, 60) hat, der senkrecht zu der jeweiligen Seitenwand und in einer Linie mit der dazwischenliegenden Trennwand (39) ist.

14. Verfahren gemäß Anspruch 12 oder 13, wobei das Paar von gegenüberliegenden Seitenwänden (24, 26) ausgebildet ist, zumindest ein darin aufgenommenes Seitenwandversteifungsmerkmal (50) zu umfassen.

15. Verfahren gemäß Anspruch 14, wobei die zumindest eine Trennendelücke (56; 38) ein Paar von Trennendelücken (56, 41; 38, 40) aufweist, und wobei das zumindest eine Seitenwandversteifungsmerkmal (50) ein jeweiliges Versteifungsmerkmal (46) angrenzend an jede Trennendelücke (38, 40) aufweist.

16. Verfahren gemäß Anspruch 12, wobei das zumindest eine Seitenwandversteifungsmerkmal ein abgerundetes Eck (46) aufweist, das durch zumindest eine Seitenwand (24) und angrenzende Teile der Basis (20) definiert ist.

17. Verfahren gemäß Anspruch 13, wobei das abgerundete Eck (46) einen Radius von weniger als 5 mm hat.

## Revendications

1. Conteneur de blindage (14) pour au moins une carte de circuits imprimés (18) d'un dispositif électronique portatif (10), le conteneur de blindage (14) comprenant :
un cadre de blindage (16) ; et
un couvercle de blindage (17) porté par le cadre de blindage ;
dans lequel le cadre de blindage (16) comprend :
une base généralement plane (20) ayant au moins une ouverture (22b) qui y est ménagée ;
une paire de parois latérales opposées (24, 26 ; 25, 26) formées d'une pièce avec ladite base (20) et s'étendant vers le haut à partir de celle-ci ;
une paire de parois d'extrémité opposées (28, 30) formées d'une pièce avec ladite base (20) et s'étendant vers le haut à partir de celle-ci ; et
au moins une paroi intermédiaire de cloisonnement (39 ; 32) formée d'une pièce avec ladite base (20) et s'étendant vers le haut à partir de celle-ci, afin de définir une pluralité de compartiments du conteneur (34, 52 ; 34, 36), ladite au moins une paroi de cloisonnement (39 ; 32) s'étendant aussi partiellement seulement entre lesdites parois latérales opposées (24, 26 ; 25, 26) afin de définir ainsi au moins un espace d'extrémité de cloisonnement (56 ; 38) ;
dans lequel au moins une desdites parois latérales comprend une paroi latérale décalée (25) qui définit au moins un compartiment plus étroit (52) ; et
dans lequel un angle arrondi est défini adjacent audit espace d'extrémité de cloisonnement (56) entre ladite paroi de cloisonnement (39), ladite paroi latérale (24) et ladite paroi latérale décalée (25), ledit angle arrondi étant défini par une extension angulaire (58) dans ladite paroi latérale (24), qui est perpendiculaire à la paroi latérale (24) et qui est alignée avec ladite paroi intermédiaire de cloisonnement (39).

2. Conteneur de blindage (14) selon la revendication 1, dans lequel deux parois latérales (24, 25) s'étendent adjacentes audit espace d'extrémité de cloisonnement (56) respectif et dans lequel chacune des parois latérale (24) et latérale décalée (25) a une extension angulaire (58, 60) qui est perpendiculaire à la paroi latérale respective et alignée avec la paroi intermédiaire de cloisonnement (39).

3. Conteneur de blindage (14) selon la revendication 1 ou 2, dans lequel ladite paire de parois latérales opposées (24, 26) comprend au moins un dispositif de raidissement de paroi latérale (50) qui lui est intégré.

4. Conteneur de blindage (14) selon la revendication 2, dans lequel ledit au moins un espace d'extrémité de cloisonnement (56 ; 38) comprend une paire d'espaces d'extrémité de cloisonnement (56, 41 ; 38, 40) et dans lequel ledit au moins un dispositif de raidissement de paroi latérale (50) comprend un dispositif de raidissement respectif (46) adjacent à chaque espace d'extrémité de cloisonnement (38, 40).

5. Conteneur de blindage (14) selon la revendication 3, dans lequel ledit au moins un dispositif de raidissement de paroi latérale comprend un angle avec congé (46) défini par au moins une paroi latérale (24) et des portions adjacentes de ladite base (20).

6. Conteneur de blindage (14) selon la revendication 5, dans lequel ledit angle avec congé (46) a un rayon de moins de 5 mm.

7. Conteneur de blindage (14) selon la revendication 4, dans lequel l'espace de chacun desdites espaces d'extrémité de cloisonnement (38, 40) est inférieur à 1 mm.

8. Conteneur de blindage (14) selon la revendication 1 ou 2, dans lequel ladite au moins une paroi intermédiaire de cloisonnement (39 ; 32) comprend une pluralité de parois intermédiaires de cloisonnement (39, 32).

9. Conteneur de blindage (14) selon la revendication 1 ou 2, dans lequel ledit cadre de blindage (16) ne présente pas de joints brasés ou soudés entre des portions adjacentes de celui-ci.

10. Dispositif électronique portatif (10) comprenant :
un boîtier portatif (11, 12) ;
un conteneur de blindage (14) au sein dudit boîtier portatif (11, 12), le conteneur étant le conteneur selon l'une quelconque des revendications 1 à 8 ; et
ladite au moins une carte de circuits imprimés (18), ladite au moins une carte de circuits imprimés étant adjacente audit conteneur de blindage.

11. Dispositif électronique portatif (10) selon la revendication 10, dans lequel ladite au moins une carte de circuits imprimés est constituée d'une carte de circuits imprimés (18) d'émetteur-récepteur sans fil.

12. Procédé de fabrication d'un conteneur de blindage (14) pour au moins une carte de circuits imprimés (18) d'un dispositif électronique portatif (10), le procédé comprenant les étapes consistant à :
former un couvercle de blindage (17) ; et
former un cadre de blindage (16) afin de porter le couvercle de blindage en exécutant au moins les étapes consistant à :
former une base plane (20) ayant au moins une ouverture qui y est ménagée ;
former une paire de parois latérales opposées (24, 26 ; 25, 26) faites d'une seule pièce avec la base (20) et s'étendant vers le haut à partir de celle-ci ;
former une paire de parois d'extrémité opposées (28, 30) faites d'une pièce avec la base (20) et s'étendant vers le haut à partir de celle-ci ; et
former au moins une paroi intermédiaire de cloisonnement (39 ; 32) faite d'une pièce avec ladite base (20) et s'étendant vers le haut à partir de celle-ci, afin de définir une pluralité de compartiments du conteneur (34, 52 ; 34, 36), ladite au moins une paroi de cloisonnement (39 ; 32) s'étendant aussi partiellement seulement entre lesdites parois latérales opposées (24, 26 ; 25, 26) afin de définir ainsi au moins un espace d'extrémité de cloisonnement (56 ; 38) ;
dans lequel le formage d'une seule pièce d'au moins une desdites parois latérales comprend le formage d'une seule pièce d'une paroi latérale décalée (25) qui définit au moins un compartiment plus étroit (52) ; et
former d'une seule pièce un angle arrondi adjacent audit espace d'extrémité de cloisonnement (56) entre ladite paroi de cloisonnement (39), ladite paroi latérale (24) et ladite paroi latérale décalée (25), ledit angle arrondi étant défini par une extension angulaire (58) dans ladite paroi latérale (24), qui est perpendiculaire à la paroi latérale (24) et qui est alignée avec la paroi intermédiaire de cloisonnement (39).

13. Procédé selon la revendication 12, dans lequel le formage de la paire de parois latérales opposées (24, 26 ; 25, 26) est tel que deux parois latérales (24, 25) sont formées de manière à s'étendre adjacentes à l'espace d'extrémité de cloisonnement respectif (56) et dans lequel chacune des parois latérale (24) et latérale décalée (25) a une extension angulaire (58, 60) qui est perpendiculaire à la paroi latérale respective et alignée avec la paroi intermédiaire de cloisonnement (39).

14. Procédé selon la revendication 12 ou 13, dans lequel ladite paire de parois latérales opposées (24, 26) est formée en incluant au moins un dispositif de raidissement de paroi latérale (50) qui y est intégré.

15. Procédé selon la revendication 14, dans lequel ledit au moins un espace d'extrémité de cloisonnement (56 ; 38) comprend une paire d'espaces d'extrémité de cloisonnement (56, 41 ; 38, 40) et dans lequel ledit au moins un dispositif de raidissement de paroi latérale comprend un dispositif de raidissement respectif (46) adjacent à chaque espace d'extrémité de cloisonnement (38, 40).

16. Procédé selon la revendication 12, dans lequel ledit au moins un dispositif de raidissement de paroi latérale (50) comprend un angle avec congé (46) défini par au moins une paroi latérale (24) et des portions adjacentes de ladite base (20).

17. Procédé selon la revendication 13, dans lequel ledit angle avec congé (46) a un rayon de moins de 5 mm.
